# EUROPEAN PATENT APPLICATION

(11) **EP 4 052 606 A1**
(43) Date of publication of application: **07.09.2022**
(21) Application number: 20881177.8
(22) Date of filing: 12.10.2020
(51) Int. Cl.: A44C 9/00, A44C 27/00, A47G 19/00, B24B 7/17, B24B 31/02, B24B 19/02, F16D 65/12, C04B 41/80, H05K 13/04

(54) **CERAMIC STRUCTURE, DECORATION MEMBER, SUCTION NOZZLE, OPTICAL MEMBER, GUIDE MEMBER, BRAKE ROTOR, DAILY COMMODITIES, AND METHOD FOR MANUFACTURING CERAMIC STRUCTURE**

(30) Priority: 29.10.2019 JP 2019196409
(71) Applicant: Kyocera Corporation, Kyoto-shi Kyoto 612-8501 (JP)
(72) Inventor: HAYASHI, Shinichi, Kyoto-shi, Kyoto 612-8501 (JP)
(74) Representative: Viering, Jentschura & Partner mbB Patent- und Rechtsanwälte
(86) International application number: PCT/JP2020/038542
(87) International publication number: WO 2021/085106

(57) **Abstract**

A ceramic structure (1) includes a recessed portion (4) formed in a surface (3) of a base (2) formed of ceramic. A surface roughness Ra of corner portions (4d) of the recessed portion (4) on an opening side is greater than a surface roughness Ra of an outer side of the recessed portion (4).

## Description

### Technical Field

Embodiments of the disclosure relate to a ceramic structure, a decorative member, an adsorption nozzle, an optical member, a guide member, a brake rotor, a daily commodity, and a method of manufacturing the ceramic structure.

### Background Art

In the related art, there is known a technique of forming a recessed portion such as a groove in a surface of a ceramic structure, and performing various processes by visually recognizing such a recessed portion (refer to Patent Document 1, for example).

### Citation List

### Patent Literature

Patent Document 1: JP 2015-191909 A

### Summary of Invention

A ceramic structure according to an aspect of an embodiment includes a recessed portion formed in a surface of a base formed of ceramic. A surface roughness Ra of corner portions of the recessed portion on an opening side is greater than a surface roughness Ra of an outer side of the recessed portion.

Further, a method of manufacturing a ceramic structure according to an aspect of an embodiment includes firing a powder compact at a predetermined temperature to form a sintered body, grinding a surface of the sintered body, forming a recessed portion in the surface of the sintered body being ground, and barrel polishing the surface of the sintered body in which the recessed portion is formed. Further, the barrel polishing uses media larger than a width of the recessed portion.

A method of manufacturing a ceramic structure according to an aspect of the embodiment includes forming a recessed portion in a surface of a powder compact, firing the powder compact in which the recessed portion is formed at a predetermined temperature to form a sintered body, and barrel polishing the surface of the sintered body. Further, the barrel polishing uses media larger than a width of the recessed portion.

### Brief Description of Drawings

FIG. 1 is a front view of a ring according to an embodiment.
FIG. 2 is a side view of the ring according to the embodiment.
FIG. 3 is an enlarged cross-sectional view of a recessed portion formed in a surface of a ceramic structure according to the embodiment.
FIG. 4 is a cross-sectional view of an adsorption nozzle assembly according to an embodiment.
FIG. 5 is a perspective view of an adsorption nozzle according to the embodiment.
FIG. 6 is a cross-sectional view of an optical member according to an embodiment.
FIG. 7 is a cross-sectional view of the optical member according to a modified example of the embodiment.
FIG. 8 is a cross-sectional view of a guide member according to an embodiment.
FIG. 9 is a perspective view of a brake rotor according to an embodiment.
FIG. 10 is a side view of a tumbler according to an embodiment.
FIG. 11 is a perspective view of a paperweight according to an embodiment.
FIG. 12 is a front view of a handle according to an embodiment.
FIG. 13 is an enlarged cross-sectional view schematically illustrating a surface of a sintered body after a grinding process.
FIG. 14 is an enlarged cross-sectional view schematically illustrating the surface of the sintered body after formation of the recessed portion.
FIG. 15 is an enlarged cross-sectional view schematically illustrating the surface of the sintered body after barrel polishing.

### Description of Embodiments

Below, embodiments of a ceramic structure, a decorative member, an adsorption nozzle, an optical member, a guide member, a brake rotor, a daily commodity, and a method of manufacturing a ceramic structure disclosed in the present application will be described with reference to the accompanying drawings. Note that this disclosure is not limited by the following embodiments.

In the related art, there is known a technique of forming a recessed portion such as a groove in a surface of a ceramic structure, and performing various processes by visually recognizing such a recessed portion.

Further, there is also known a decorative member or the like aesthetically enhanced by forming a recessed portion in a surface of a ceramic structure and using such a recessed portion as a part of a design. In such a decorative member, visibility of the recessed portion is directly related to the aesthetics, and thus it is especially important to improve the visibility of the recessed portion.

Nevertheless, in the techniques of the related art, there is room for improvement in the visibility of the recessed portion formed in the surface of the ceramic structure.

Therefore, realization of a ceramic structure that can overcome the problems described above and improve the visibility of the recessed portion formed in the surface is expected.

### Decorative Member

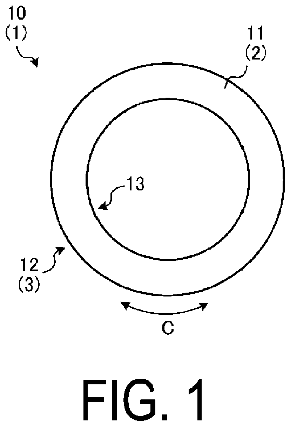

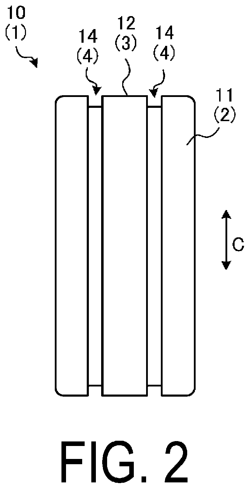

First, a configuration of a decorative member to which a ceramic structure 1 according to an embodiment is applied will be described with reference to FIGS. 1 to 3. Note that, herein, details of a ring 10, which is an example of a decorative member, will be described. FIG. 1 is a front view of the ring 10 according to the embodiment, and FIG. 2 is a side view of the ring 10 according to the embodiment.

The ring 10 according to the embodiment is composed of the ceramic structure 1. As illustrated in FIG. 1, the ring 10 according to the embodiment includes a base 11 having a ring shape, and such a base 11 includes an outer peripheral surface 12 and an inner peripheral surface 13. The base 11 of the ring 10 corresponds to a base 2 of the ceramic structure 1, and the outer peripheral surface 12 of the ring 10 corresponds to a surface 3 of the ceramic structure 1.

The base 2 (base 11) is formed of ceramic. Examples of the ceramic constituting the base 2 include oxide ceramics such as alumina (Al₂O₃), zirconia (ZrO₂), and spinel (MgAl₂O₄), and non-oxide ceramics such as silicon carbide (SiC), silicon nitride (Si₃N₄), aluminum nitride (AlN), titanium nitride (TiN), and titanium carbide (TiC).

In the present disclosure, the main component of the base 2 is preferably zirconia, alumina, zirconia-alumina complex, or silicon carbide. As a result, high mechanical characteristics can be imparted to the ceramic structure 1.

Note that the term "main component" in the present disclosure refers to 55% by mass or more, given 100% by mass as a total of the constituent components. Note that the zirconia-alumina composite being the main component refers to materials in which the total content of zirconia and alumina is 55 mass% or more, and may include not only those with a high zirconia content but also those with a high alumina content.

Further, as illustrated in FIG. 2, a recessed portion 14 having a groove shape is formed in the outer peripheral surface 12 of the ring 10. The recessed portion 14 of the ring 10 corresponds to a recessed portion 4 of the ceramic structure 1. For example, as illustrated in FIG. 2, a plurality (two in the drawing) of the recessed portions 14 having a groove shape and extending in a circumferential direction C of the base 11 are formed in the outer peripheral surface 12 of the ring 10.

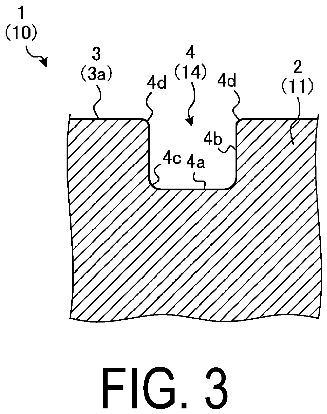

FIG. 3 is an enlarged cross-sectional view of the recessed portion 4 formed in the surface 3 of the ceramic structure 1 according to the embodiment. As illustrated in FIG. 3, the recessed portion 4 includes a bottom surface 4a, side surfaces 4b, corner portions 4c on a bottom side, and corner portions 4d on an opening side.

The corner portions 4c on the bottom side are each a corner portion formed in a portion where the bottom surface 4a and the side surface 4b are in contact, and have a curved shape with a predetermined radius of curvature. Further, the corner portions 4d on the opening side are each a corner portion formed in a portion where the side surface 4b and a surface 3a of the surface 3 on the outer side of the recessed portion 4 are in contact, and have a curved shape with a predetermined radius of curvature.

Here, in the embodiment, a surface roughness Ra of the corner portions 4d on the opening side is greater than a surface roughness Ra of the surface 3a on the outer side of the recessed portion 4. That is, in the embodiment, the surface of each corner portion 4d on the opening side positioned at an edge of the recessed portion 4 is rougher than the surface 3a on the outer side of the edge of the recessed portion 4.

In this way, when light strikes the surface 3 in which the recessed portion 4 is formed, a diffused reflection occurs at each edge of the recessed portion 4 (that is, corner portion 4d on the opening side), while a diffused reflection is less likely to occur at the surface 3a on the outer side of the edge of the recessed portion 4.

Thus, according to the embodiment, this allows the contour of the recessed portion 4 to stand out clearly, improving the visibility of the recessed portion 4 formed in the surface 3 of the ceramic structure 1.

Further, in the embodiment, the surface roughness Ra of the corner portions 4d on the opening side is preferably greater than a surface roughness Ra of an inner portion of the recessed portion 4, such as the bottom surface 4a and the side surfaces 4b of the recessed portion 4, for example.

In this way, when light strikes the surface 3 in which the recessed portion 4 is formed, a diffused reflection occurs at each edge of the recessed portion 4 (that is, corner portions 4d on the opening side), while a diffused reflection is less likely to occur at the inner side of the recessed portion 4 (bottom surface 4a and side surfaces 4b).

Thus, according to the embodiment, this allows the contour of the recessed portion 4 to stand out more clearly, further improving the visibility of the recessed portion 4 formed in the surface 3 of the ceramic structure 1.

Further, in the embodiment, the radius of curvature of the corner portions 4d on the opening side is preferably smaller than the radius of curvature of the corner portions 4c on the bottom side. This allows the contour of the recessed portion 4 to stand out more clearly because the light is clearly reflected by the corner portions 4d on a sharper opening side.

Thus, according to the embodiment, the visibility of the recessed portion 4 formed in the surface 3 of the ceramic structure 1 can be further improved.

Further, in the embodiment, the surface 3a on the outer side of the recessed portion 4 preferably has a satin finish. This makes it possible to improve the aesthetics of the ring 10 as a decorative member.

Further, in the embodiment, the inner portion of the recessed portion 4 preferably has a mirror finish. This makes it possible to improve the aesthetics of the ring 10 as a decorative member.

Note that in the embodiment described above, the ring 10 is illustrated as an example of a decorative member, but the decorative member to which the ceramic structure 1 according to the above-described embodiment is applicable is not limited to the ring 10. For example, by applying the ceramic structure 1 to a clock that is a decorative member, it is possible to improve the visibility of the recessed portion 4 formed in the surface 3 of such a clock.

### Adsorption Nozzle Assembly

Further, the object to which the ceramic structure 1 described above is applicable is not limited to a decorative member. Therefore, in the following embodiment, examples are illustrated in which the ceramic structure 1 is applied to various other objects.

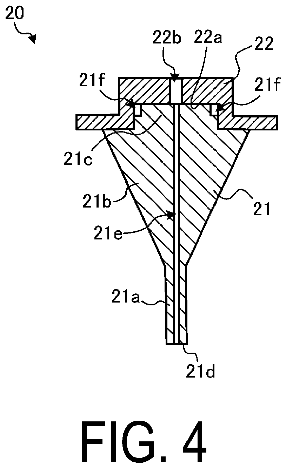

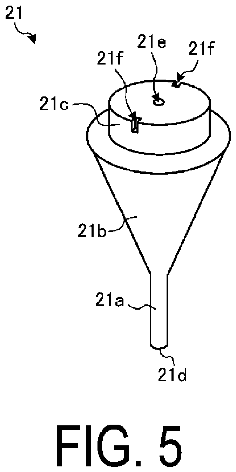

First, a configuration of an adsorption nozzle assembly 20 to which the ceramic structure 1 according to the embodiment is applied will be described with reference to FIGS. 4 and 5. FIG. 4 is a cross-sectional view of the adsorption nozzle assembly 20 according to the embodiment, and FIG. 5 is a perspective view of an adsorption nozzle 21 according to the embodiment.

As illustrated in FIG. 4, the adsorption nozzle assembly 20 according to the embodiment includes the adsorption nozzle 21 and a flange 22. Further, as illustrated in FIG. 5, the adsorption nozzle 21 has a tapered shape, and includes a leading end portion 21a, a cone portion 21b, and a mounting portion 21c in this order from the side of the electronic component to be adsorbed. The adsorption nozzle 21 includes the ceramic structure 1 according to an embodiment.

Further, as illustrated in FIG. 4, the adsorption nozzle 21 includes a through hole 21e formed from an adsorption surface 21d of the leading end portion 21a through the cone portion 21b and the mounting portion 21c. The adsorption surface 21d is a surface that is provided on the leading end portion 21a and comes into contact with the electronic component to be adsorbed. The mounting portion 21c is a portion mounted to a receiving portion 22a of the flange 22.

As illustrated in FIG. 4, the flange 22 includes the receiving portion 22a and a communication hole 22b that leads to the through hole 21e of the adsorption nozzle 21, and is a tubular body that encloses the mounting portion 21c of the adsorption nozzle 21. The flange 22 is composed of, for example, a metal member of stainless steel, an aluminum alloy, or the like.

In the adsorption nozzle assembly 20, the mounting portion 21c of the adsorption nozzle 21 and the receiving portion 22a of the flange 22 are fitted together to form a single unit. Then, in the adsorption nozzle assembly 20, the communication hole 22b in the flange 22 and the through hole 21e in the adsorption nozzle 21 are connected, and thus function as a suction hole for adsorbing an electronic component or the like.

Here, in the adsorption nozzle assembly 20 according to the embodiment, a recessed portion 21f having a notched shape is formed in the mounting portion 21c of the adsorption nozzle 21. Such a recessed portion 21f is a mark for detecting and aligning a position of the mounting portion 21c when the mounting portion 21c of the adsorption nozzle 21 is fitted to the receiving portion 22a of the flange 22 by a robot.

Then, such a recessed portion 21f corresponds to the recessed portion 4 of the ceramic structure 1 described above. Accordingly, in the adsorption nozzle assembly 20 according to the embodiment, when the mounting portion 21c of the adsorption nozzle 21 is fitted to the receiving portion 22a of the flange 22 by the robot, the mounting portion 21c can be accurately aligned.

Further, in the embodiment, a surface of the mounting portion 21c preferably has a satin finish. This makes it possible to prevent halation when detecting the position of the recessed portion 21f by a camera or the like. Thus, according to the embodiment, when the mounting portion 21c of the adsorption nozzle 21 is fitted to the receiving portion 22a of the flange 22 by the robot, the mounting portion 21c can be more accurately aligned.

### Optical Member

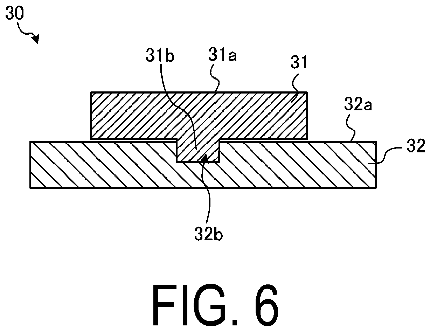

Next, a configuration of an optical member 30 to which the ceramic structure 1 according to the embodiment is applied will be described with reference to FIG. 6. FIG. 6 is a schematic cross-sectional view of the optical member 30 according to an embodiment.

The optical member 30 according to the embodiment has a predetermined reflectance and is used as: a reference plate that serves as a reference for reflectance in a device that measures a concentration of glucose or other substance; a member that reflects light in an optical measurement device for adjusting errors in rotating machinery; or the like.

The optical member 30 according to the embodiment includes a reflective portion 31 that reflects light, and a support portion 32 that supports such a reflective portion 31. The reflective portion 31 includes a reflective surface 31a and a protruding portion 31b.

The reflective surface 31a is a surface having a predetermined reflectance. The protruding portion 31b is provided on a side opposite to the reflective surface 31a, and is a portion supported by the support portion 32. The reflective portion 31 is formed of a ceramic (white ceramic, for example) having a high reflectance, for example.

The support portion 32 includes a main surface 32a and a recessed portion 32b formed in such a main surface 32a. The recessed portion 32b is configured to be fitted with the protruding portion 31b of the reflective portion 31. Then, in the optical member 30, the protruding portion 31b of the reflective portion 31 and the recessed portion 32b of the support portion 32 are fitted together and integrated by fixation by an adhesive (not illustrated).

Here, the support portion 32 is composed of the ceramic structure 1 according to the embodiment. Then, the recessed portion 32b corresponds to the recessed portion 4 of the ceramic structure 1. Accordingly, in the optical member 30 according to the embodiment, a position of the recessed portion 32b can be accurately detected, making accurate alignment possible when fitting the protruding portion 31b of the reflective portion 31 to the recessed portion 32b of the support portion 32 by a robot.

Further, in the embodiment, because the surface of the corner portions of the recessed portion 32b on the opening side are roughened, an anchor effect can be obtained at such corner portions on the opening side.

Further, in the embodiment, the main surface 32a of the support portion 32 preferably has a satin finish. This makes it possible to reduce the reflectance of the main surface 32a, and thus improve the efficiency of light obtained from the reflective portion 31.

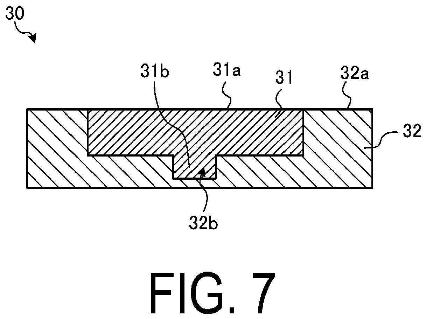

Note that the configuration of the optical member 30 according to the embodiment is not limited to the example of FIG. 6. FIG. 7 is a cross-sectional view of the optical member 30 according to a modified example of the embodiment. As illustrated in FIG. 7, in the optical member 30, the entire reflective portion 31 may be embedded in the main surface 32a of the support portion 32.

### Guide Member

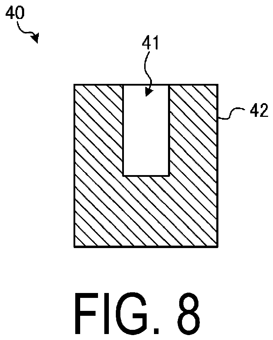

Next, a configuration of a guide member 40 to which the ceramic structure 1 according to the embodiment is applied will be described with reference to FIG. 8. FIG. 8 is a cross-sectional view of the guide member 40 according to an embodiment. The guide member 40 according to the embodiment is used to hold a thread-like member (hereinafter, also referred to as the thread) in a movable state.

Such a guide member 40 is composed of the ceramic structure 1 according to the embodiment, and includes a recessed portion 41 having a groove shape. Then, such a recessed portion 41 corresponds to the recessed portion 4 of the ceramic structure 1 described above. Accordingly, in the guide member 40 according to the embodiment, a position of the recessed portion 41 can be accurately detected, making it possible to accurately align the thread when the thread is passed through the recessed portion 41 by a robot.

Further, in the embodiment, an inner portion of the recessed portion 41 preferably has a mirror finish. Thus, the thread can be easily slid in the inner portion of the recessed portion 41.

Further, in the embodiment, a surface 42 of the guide member 40 preferably has a satin finish. Thus, a surface area of the surface 42 can be increased, making it possible to more efficiently dissipate heat generated when the thread slides in the inner portion of the recessed portion 41. Furthermore, in the embodiment, with the surface 42 of the guide member 40 being given a satin finish, a friction force of the surface 42 is improved, making it possible for a worker to easily handle the guide member 40.

### Brake Rotor

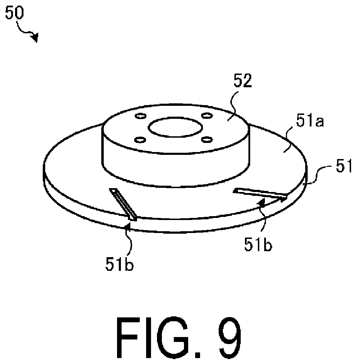

Next, a configuration of a brake rotor 50 to which the ceramic structure 1 according to the embodiment is applied will be described with reference to FIG. 9. FIG. 9 is a perspective view of the brake rotor 50 according to an embodiment.

As illustrated in FIG. 9, the brake rotor 50 according to the embodiment includes a sliding portion 51 and an anchoring portion 52. The sliding portion 51 has a disc shape, and includes a sliding surface 51a and a plurality of recessed portions 51b. The sliding surface 51a is a portion that slides with a brake pad (not illustrated) to produce a frictional resistance. The plurality of recessed portions 51b are formed in the sliding surface 51a. The anchoring portion 52 has a cylindrical shape and is anchored to a wheel (not illustrated).

Note that the sliding surface 51a and the plurality of recessed portions 51b are provided on both main surfaces of the sliding portion 51 having a disc shape. Then, with the sliding portion 51 interposed between a pair of brake pads, the brake rotor 50 and the pair of brake pads function as a brake.

Here, the sliding portion 51 includes the ceramic structure 1 according to the embodiment. Then, the recessed portion 51b of the sliding portion 51 corresponds to the recessed portion 4 of the ceramic structure 1. By thus roughening edges of the recessed portions 51b, it is possible to improve the friction force between the sliding surface 51a and the brake pads when the sliding surface 51a slides with the brake pads.

Thus, according to the embodiment, the performance of the brake on which the brake rotor 50 is mounted can be improved.

Further, in the embodiment, the sliding surface 51a preferably has a satin finish. This can further improve the friction force between the sliding surface 51a and the brake pad when the sliding surface 51a slides with the brake pad, thereby further improving the performance of the brake on which the brake rotor 50 is mounted.

Further, in the embodiment, an inner portion of the recessed portion 51b preferably has a mirror finish. As a result, brake pad debris accumulated in the inner portion of the recessed portion 51b can be easily discharged. Note that the anchoring portion 52 may be integrally formed with the sliding portion 51 by the ceramic structure 1, or may be formed of a material different from that of the sliding portion 51.

### Daily Commodity

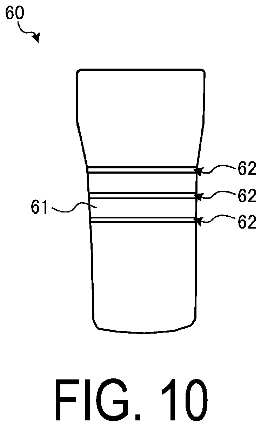

Next, configurations of various daily commodities to which the ceramic structure 1 according to the embodiment is applied will be described with reference to FIGS. 10 to 12. First, details of a tumbler 60, which is an example of a daily commodity, will be described. FIG. 10 is a side view of the tumbler 60 in accordance with an embodiment.

The tumbler 60 according to the embodiment is a daily commodity having a cup shape that opens upward, and is used by a user to consume a beverage by pouring such a beverage into an inner portion from such an opening.

The tumbler 60 is composed of the ceramic structure 1 according to the embodiment, and includes a holding portion 61 on a side surface. The holding portion 61 is a portion held by the user. Further, a plurality (three in the drawing) of recessed portions 62 having a groove shape are formed in the holding portion 61.

With the groove-shaped recessed portions 62 thus formed in the holding portion 61, the holding portion 61 is less slippery, making it possible for the user to easily hold the holding portion 61.

Here, the recessed portion 62 of the holding portion 61 corresponds to the recessed portion 4 of the ceramic structure 1. Edges of the recessed portions 62 are thus roughened, making the holding portion 61 even less slippery. Thus, according to the embodiment, the user can more easily hold the holding portion 61.

Further, in the embodiment, a surface of the holding portion 61 preferably has a satin finish. This makes the holding portion 61 even less slippery, making it even easier for the user to hold the holding portion 61.

Further, in the embodiment, the inner portions of the recessed portions 62 preferably have a mirror finish. As a result, water droplets and the like accumulated in the inner portions of the recessed portions 62 can be easily discharged.

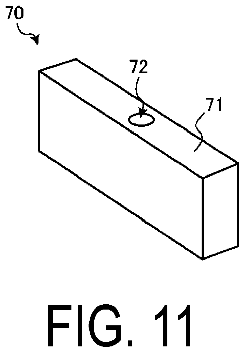

Next, details of a paperweight 70, which is another example of a daily commodity, will be described. FIG. 11 is a perspective view of the paperweight 70 according to an embodiment. Such a paperweight 70 is a member placed on top of paper or the like placed on a flat surface such as a desk to prevent such paper from moving, and is composed of the ceramic structure 1 according to the embodiment.

As illustrated in FIG. 11, the paperweight 70 has a substantially rectangular parallelepiped shape, and a recessed portion 72 having a cylindrical shape is formed in an upper surface 71. Such a recessed portion 72 is a portion used for holding a writing implement such as a pen.

Here, the recessed portion 72 of the upper surface 71 corresponds to the recessed portion 4 of the ceramic structure 1. Edges of the recessed portion 72 are thus roughened, making it less likely that the writing implement will slip. Thus, according to the embodiment, the writing implement can be easily fixed in the paperweight 70.

Further, in the embodiment, a surface of the paperweight 70 preferably has a satin finish. This makes the surface of the paperweight 70 less slippery, making it possible for the user to easily hold the paperweight 70.

Further, in the embodiment, an inner portion of the recessed portion 72 preferably has a mirror finish. This makes the inner portion of the recessed portion 72 more slippery, making it possible to easily remove the writing implement from the recessed portion 72.

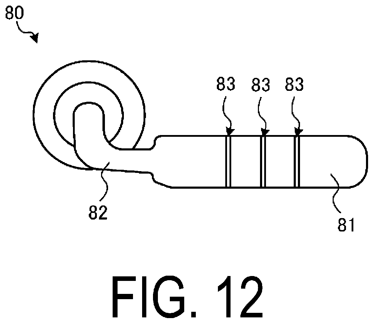

Next, details of a handle 80, which is another example of a daily commodity, will be described. FIG. 12 is a front view of the handle 80 according to an embodiment. Such a handle 80 is a member used when opening or closing a door installed in a room or the like.

As illustrated in FIG. 12, the handle 80 includes a handle portion 81 and a connection portion 82. The handle portion 81 is a portion gripped by a user. The connection portion 82 is a portion that connects the handle portion 81 and the door (not illustrated).

Further, a plurality (three in the drawing) of recessed portions 83 having a groove shape are formed in the handle portion 81. With the recessed portions 83 having a groove shape thus formed in the handle portion 81, the handle portion 81 is less slippery, making it possible for the user to easily grip the handle portion 81.

Here, the handle portion 81 is composed of the ceramic structure 1 according to the embodiment. Then, the recessed portion 83 corresponds to the recessed portion 4 of the ceramic structure 1. Edges of the recessed portions 83 are thus roughened, making the handle portion 81 even less slippery. Thus, according to the embodiment, the user can more easily grip the handle portion 81.

Further, in the embodiment, a surface of the handle portion 81 preferably has a satin finish. This makes the surface of the handle portion 81 less slippery, making it possible for the user to grip the handle portion 81 even more easily.

Further, in the embodiment, inner portions of the recessed portions 83 preferably have a mirror finish. As a result, sweat of the user, debris, and the like accumulated in the inner portions of the recessed portions 83 can be easily discharged.

Note that, in the embodiments described above, the tumbler 60, the paperweight 70, and the handle 80 are illustrated as examples of a daily commodity, but the daily commodity to which the ceramic structure 1 according to the above-described embodiment is applicable is not limited to such examples.

### Examples

In the following, an example of the present disclosure will be specifically described. Note that the ceramic structure 1 (ring 10) with zirconia as the main component is illustrated in the example described below, but the present disclosure is not limited to the example below.

First, a mixed powder was prepared with zirconia as the main component, yttria (Y₂O₃) as a stabilizer, and various additive elements (iron oxide, chromium oxide, titanium oxide, and the like) in a predetermined ratio. Then, a predetermined amount of water as a solvent was added to the prepared mixed powder, and the materials were mixed and pulverized in a vibrating mill, a ball mill, or the like, and a slurry was obtained.

Next, predetermined amounts of various binders were added to the obtained slurry and the mixture was dried by a spray drying method to obtain granules. Then, the obtained granules were used to obtain a powder compact having a cylindrical shape using a desired pressing method such as, for example, dry pressing, cold isostatic pressing, or the like.

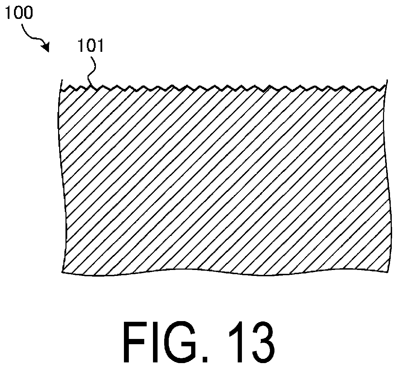

Next, a through hole was formed in the obtained cylindrical powder compact to form a ring shape. Then, the obtained powder compact was degreased and subsequently held and fired at a predetermined temperature (from 1300 to 1500°C, for example) for a predetermined time (from 1 to 3 hours, for example) in an air atmosphere to obtain a sintered body 100 (refer to FIG. 13) having a ring shape.

Next, the obtained sintered body 100 having a ring shape was put into a predetermined grinder, and a surface 101 (refer to FIG. 13), such as an inner peripheral surface or an outer peripheral surface, was ground using a diamond grindstone of a predetermined number. FIG. 13 is an enlarged cross-sectional view schematically illustrating the surface 101 of the sintered body 100 after the grinding process.

The number of the diamond grindstone used in such a grinding process of the sintered body 100 is relatively low, and thus the surface 101 after the grinding process is relatively rough, as illustrated in FIG. 13.

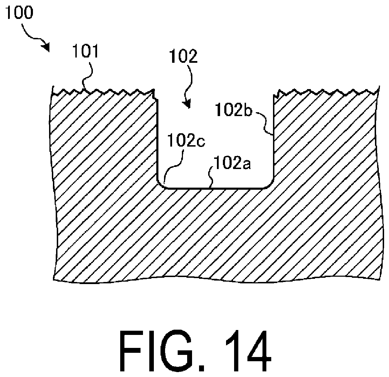

Next, the ground sintered body 100 was put into a predetermined grinder and a process of forming a recessed portion 102 (FIG. 14) having a groove shape in the surface 101 using a diamond grindstone of a predetermined number was carried out. FIG. 14 is an enlarged cross-sectional view schematically illustrating the surface 101 of the sintered body 100 after formation of the recessed portion 102.

The number of the diamond grindstone used in such a formation process of the recessed portion 102 is relatively high, and thus an inner portion of the recessed portion 102 (bottom surface 102a, side surfaces 102b, and corner portions 102c on a bottom side of the recessed portion 102, for example) after the recessed portion formation process has a mirror finish, as illustrated in FIG. 14.

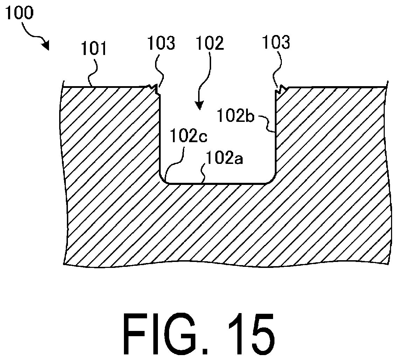

Next, the sintered body 100 subjected to the recessed portion formation process was put into a predetermined barrel polishing machine and subjected to a barrel polishing process for forming a satin finish on the surface 101 using media of a predetermined size. FIG. 15 is an enlarged cross-sectional view schematically illustrating the surface 101 of the sintered body 100 after barrel polishing.

Here, in the embodiment, in such a barrel polishing process, media having a width larger than the width of the recessed portion 102 having a groove shape are used. For example, in a case in which the width of the recessed portion 102 is 1 mm, media having a size of 2 mm or greater are used in the barrel polishing process.

This allows the media to unproblematically strike the surface 101 on an outer side of the recessed portion 102, making it possible to treat the surface to the desired satin finish. On the other hand, the media does not readily strike corner portions 103 of the recessed portion 102 on the opening side, making it difficult to treat the surface to the desired satin finish.

Therefore, as illustrated in FIG. 15, at the corner portions 103 on the opening side, the rough surface state obtained after grinding is relatively maintained.

Lastly, the barrel-polished sintered body 100 was washed to obtain two ceramic structures 1 (rings 10) of the present disclosure.

The sintered body 100 described thus far corresponds to the ceramic structure 1, the surface 101 corresponds to the surface 3 of the ceramic structure 1, the recessed portion 102 corresponds to the recessed portion 4 of the ceramic structure 1, and the corner portions 103 on the opening side correspond to the corner portions 4d of the ceramic structure 1 on the opening side.

Then, the surface roughness Ra of the outer side of the recessed portion 4, the corner portion 4d of the recessed portion 4 on the opening side, and the inner portion of the recessed portion 4 were respectively measured for the two obtained samples. Such a surface roughness Ra was measured by the surface roughness measurement method specified in JIS B 0601 (1994) using a two-dimensional stylus type roughness measuring instrument. The results are shown in Table 1.

### [Table 1]

**Table 1**

| Sample No. | Outer portion of recessed portion (µm) | Corner portion of recessed portion on opening side (µm) | Inner portion of recessed portion (µm) |
|---|---|---|---|
| 1 | 0.22 | 0.66 | 0.18 |
| 2 | 0.23 | 0.60 | 0.20 |

As shown in Table 1, in the ceramic structure 1 according to the embodiment, it can be seen that the surface roughness Ra of the corner portion 4d on the opening side is greater than the surface roughness Ra on the outer side of the recessed portion 4. This allows the contour of the recessed portion 4 to stand out clearly, thus improving the visibility of the recessed portion 4 formed in the surface 3 of the ceramic structure 1.

Further, as shown in Table 1, in the ceramic structure 1 according to the embodiment, it can be seen that the surface roughness Ra of the corner portion 4d on the opening side is greater than the surface roughness Ra of the inner portion the recessed portion 4. This allows the contour of the recessed portion 4 to stand out more clearly, thus further improving the visibility of the recessed portion 4 formed in the surface 3 of the ceramic structure 1.

Further, in the embodiment, media larger than the width of the recessed portion 102 is used in the barrel polishing process, making it possible to increase the surface roughness Ra only in the corner portions 4d on the opening side, without separately masking the corner portions 4d on the opening side. That is, in the embodiment, the visibility of the recessed portion 4 can be improved by a simple process.

Although embodiments of the present disclosure are described above, the present disclosure is not limited to the embodiments described above, and various modifications can be made without departing from the spirit thereof. For example, in the embodiment described above, a process of forming the recessed portion 102 was carried out after formation of the sintered body 100, but the process of forming the recessed portion 102 may be carried out before formation of the sintered body 100.

That is, in this example, the sintered body 100 with the recessed portion 102 formed therein is obtained by forming the recessed portion 102 in the powder compact pressed into a ring shape using a predetermined technique and then firing the powder compact at a predetermined temperature for a predetermined time.

Then, the barrel polishing process is performed on the obtained sintered body 100 using media larger than the width of the recessed portion 102 having a groove shape. Thus, the ceramic structure 1 similar to the embodiment described above can be obtained.

Additional effects and other variations can be easily derived by a person skilled in the art. Thus, a wide variety of aspects of the present disclosure are not limited to the specific details and representative embodiments represented and described above. Accordingly, various changes are possible without departing from the spirit or scope of the general concepts of the disclosure defined by the appended claims and their equivalents.

### Reference Signs List

1 Ceramic structure
2 Base
3 Surface
4 Recessed portion
4a Bottom surface
4b Side surface
4c Corner portion on bottom side
4d Corner portion on opening side
10 Ring
11 Base
12 Outer peripheral surface
14 Recessed portion
20 Adsorption nozzle assembly
21 Adsorption nozzle
21c Mounting portion
21f Recessed portion
22 Flange
30 Optical member
31 Reflective portion
31b Protruding portion
32 Support portion
32b Recessed portion
40 Guide member
41 Recessed portion
50 Brake rotor
51 Sliding portion
51a Sliding surface
51b Recessed portion
60 Tumbler
61 Holding portion
62 Recessed portion
70 Paperweight
72 Recessed portion
80 Handle
83 Recessed portion

## Claims

1. A ceramic structure comprising:
a recessed portion formed in a surface of a base formed of ceramic, wherein
a surface roughness Ra of corner portions of the recessed portion on an opening side is greater than a surface roughness Ra of an outer side of the recessed portion.

2. The ceramic structure according to claim 1, wherein
the surface roughness Ra of the corner portions of the recessed portion on the opening side is greater than a surface roughness Ra of an inner portion of the recessed portion.

3. The ceramic structure according to claim 1 or 2, wherein
the corner portions of the recessed portion on the opening side and corner portions of the recessed portion on a bottom side each have a curved shape, and
a radius of curvature of the corner portions of the recessed portion on the opening side is smaller than a radius of curvature of the corner portions of the recessed portion on the bottom side.

4. A decorative member comprising:
the ceramic structure according to any one of claims 1 to 3.

5. An adsorption nozzle comprising:
the ceramic structure according to any one of claims 1 to 3, wherein
the recessed portion is formed for alignment.

6. An optical member comprising:
a reflective portion comprising a protruding portion; and
a support portion comprising the ceramic structure according to any one of claims 1 to 3, wherein
the recessed portion is configured to be fitted to the protruding portion.

7. A guide member comprising:
the ceramic structure according to any one of claims 1 to 3, wherein
the recessed portion is configured to guide a thread.

8. A brake rotor comprising:
a sliding portion comprising a ceramic structure according to any one of claims 1 to 3, wherein
the recessed portion is formed in a sliding surface configured to slide with a brake pad to produce a frictional resistance.

9. A daily commodity comprising:
the ceramic structure according to any one of claims 1 to 3.

10. A method of manufacturing a ceramic structure, the method comprising:
firing a powder compact at a predetermined temperature to form a sintered body;
grinding a surface of the sintered body;
forming a recessed portion in the surface of the sintered body being ground; and
barrel polishing the surface of the sintered body in which the recessed portion is formed, wherein
the barrel polishing uses media larger than a width of the recessed portion.

11. The method of manufacturing a ceramic structure according to claim 10, wherein
the forming the recessed portion comprises mirror finishing an inner portion of the recessed portion.

12. A method of manufacturing a ceramic structure, the method comprising:
forming a recessed portion in a surface of a powder compact;
firing the powder compact in which the recessed portion is formed at a predetermined temperature to form a sintered body; and
barrel polishing the surface of the sintered body, wherein
the barrel polishing uses media larger than a width of the recessed portion.
